# EUROPEAN PATENT SPECIFICATION

(11) **EP 1 076 106 B1**
(45) Date of publication and mention of the grant of the patent: **08.10.2003**
(21) Application number: 99810714.8
(22) Date of filing: 09.08.1999
(51) Int. Cl.: C23C 4/00, F01D 5/28

(54) **Process for masking cooling holes of a gas turbine component**
Verfahren zum Abdecken von Kühlungsöffnungen eines Gasturbinenbauteils
Procédé pour couvrir les orifices de refroidissement d'un composant d'une turbine à gaz

(43) Date of publication of application: 14.02.2001
(60) Divisional application: 02010908.8
(73) Proprietor: ALSTOM (Switzerland) Ltd, 5401 Baden (CH)
(72) Inventor: Beeck, Alexander, Dr., 79790 Küssaberg (DE); Bögli, Andreas, 5430 Wettingen (CH); Fernihough, John, Dr., 5408 Ennetbaden (CH)

(56) References cited:
- EP-A- 0 843 026
- US-A- 5 902 647

## Description

### FIELD OF INVENTION

The invention relates to a process of masking cooling holes of a gas turbine component.

### STATE OF THE ART

Components such as gas turbine blades, vanes and other cooled parts often contain cavities that distribute cooling air to a plurality of holes in the wall of the part that lead to the outer surface. Most turbine components are coated for protection from oxidation and/or corrosion with, for example, a MCrAIY coating (base coat) and some are also coated with a thermal barrier coating (TBC) for thermal insulation. The demands of operation of the parts in a gas turbine often lead to the degradation of the coating before the structural integrity of the underlying part itself is degraded. Hence, the base coat and TBC must be removed and re-applied.

The re-application of the coatings can be very problematic for parts with a large number of cooling holes. Often the base coat can reach thicknesses of 150-300 µm, and the TBC may be another 200 ― 500 µm in thickness. The combined thicknesses of these coatings would have a very significant (and negative) influence on the effectiveness of the cooling holes if the coatings were deposited into these holes, especially considering that some holes are 1 mm or less in diameter. Specially shaped cooling holes are particularly susceptible to this as their effectiveness depends heavily on the accuracy of the shape of the hole.

There have been several disclosures relating to this problem and there are several widely known practices. Those skilled in the art are aware that a common practice is to braze or weld the holes closed with a suitable material after the old coatings have been removed, re-apply the new coatings, and re-manufacture the holes. The problem with this is that the brazing or welding operations introduce zones of weakness into the material. Normal hole manufacturing operations have errors associated with the placement of the holes, and when residual welding or brazing material is left, the zones of weakness go into operation with the part and compromise the mechanical integrity of the part.

One disclosure which offers a solution to this is US 5,702,288, in which an abrasive slurry is injected into the cavity of the component and forced through the cooling holes which were partially covered by the coating material. There was no welding or brazing closed prior to coating. However this also abrades the internal cooling configuration (ribs), any inserts, and also the non-coated portion of the cooing holes.

Another disclosure which offers a better solution is US 4,743,462, in which fugitive plugs are inserted into the cooling holes and partially volatilize during the coating process. The volatilization disrupts the coating in the region of the hole, and once the plugs are completely removed the holes are essentially free of coating and the cooling air will be unimpeded. The disadvantage of this method is that the large portion of the plug which blocks the surface does not constitute an even continuation of the cooling passage (it is specified to be larger than the cooling hole opening), therefore the path of the cooling air will be different from the intention of the original cooling holes design. This is particularly true for film cooling holes and specially shaped holes which are highly dependent on the shape of the hole near the external surface of the part. If the walls of the cooling holes are not maintained straight all the way through the coating layers (again, MCrAIY and TBC may amount to 0.8 mm or more in thickness) the cooling efficiency will be significantly compromised.

A further disadvantage of the method disclosed in US 4,743,462 is that the plugs must all be placed individually into the cooling holes. For small simple aero-engine parts such as the one illustrated in the disclosure (containing only several rows of cooling holes at the leading edge) this is feasible, however for large turbine components of land-based gas turbines which may contain several hundred cooling holes, it is no longer feasible to individually place plugs into each hole. This is further complicated by the fact that each component may be manufactured with several different types of cooling hole ― including conical, straight cylindrical and holes with changing wall angles. Each type of cooling hole would require its own specially designed plug.

A further disclosure in which all holes are plugged at once is given in US 5,800,695. A masking agent is placed into the cooling configuration and forced through until it fills the cooling holes from the inside, but only up to the level of the exterior surface of the component. A coating is then applied, in this case electrolytically applied platinum. Due to the non-conductivity of the plastic maskant cited in the disclosure, no Pt would deposit on the masking agent in the cooling holes. However, if the coating were deposited using thermal spraying techniques, it would coat over the maskant in the cooling holes, forming a layer that would remain after maskant removal. This layer would have to be removed. No solution is offered for this problem ― in particular, how to remove the layer of coating material in such a way that the intended cooling hole design is maintained through the thickness of the coating material.

In addition, only plastic materials are specified as maskant materials, and in US 4,743,462 the mask material is specified to volatilize at a temperature below that of the deposition process. The problem with this is that part requiring a MCrAIY coating and TBC must have the MCrAIY coating "diffusion bonded" by a high temperature heat treatment (about 1000°C ― 1150°C in vacuum) before the TBC can be applied. These specified materials would not be retained for the TBC coating process, and would either have to be re-applied, or the advantage of the masking would be lost. Indeed, in patent US 5,800,695 the example process clearly states that after electrolytic platinum coating, the maskant is removed and then the parts are aluminized, with no mention of protecting the cooling holes from Al deposition.

### SUMMARY OF THE INVENTION

It is object of the present invention to find a process of masking all cooling holes of a gas turbine component at once, with the mask defining the walls of the cooling holes beyond the external surface of the component so that the deposited coating material forms the intended shape of the cooling hole. According to the invention a process was found of masking cooling holes of a gas turbine component with an external surface, comprising a cavity and a plurality of cooling holes, before coating the gas turbine component, characterised in that Process of masking cooling holes (4) of a gas turbine component with an external surface, comprising a cavity and a plurality of cooling holes before coating the gas turbine component, characterised in that masking of both the external surface of the component and the cooling holes with a mask material, exposing the cooling holes to at least one energy source from the cavity of the component and thereby thickening the mask material within the cooling holes and along the line-of-sight through the cooling holes beyond the external surface of the component, removing mask material unaffected by the energy source from the external surface of the component, coating the component and the masked cooling holes and removing the thickened mask material from the cooling holes.
The most important improvement of the present invention over the prior art is that the cooling holes are re-formed during the coating deposition processes to their originally intended design, even through the thickness of the applied coating. In addition, the "line-of-sight" concept is a novel and very important part of the process. Due to the manufacturing process with which the cooling holes are produced, which will be normally laser drilling, the "line-of-sight" of energy along the cooling holes from within the cavity of the component will very closely re-produce the original hole design above the external surface of the part through thickness of the coatings to be applied. Different energy sources and different mask materials may be used with special advantage for the process of the invention. The mask material may contain particles of solid material so that after thickening and with the proper heat treatment to volatilize part of the mask material, a porous solid form is left which can withstand the high temperatures of the diffusion heat treatment necessary for the bonding between base material of the component and the MCrAIY coating, before applying the thermal barrier coating (TBC). An other advantage is achieved when an insert is placed into the cavity of the component to avoid liquid mask material entering into the cavity and then thickening. It is possible that insert itself is the source of energy, which offers certain advantages.

### SHORT DESCRIPTION OF THE DRAWINGS

It is shown by
- **Fig. 1**: gas turbine blade with cooling configuration,
- **Fig. 2**: section by line II-II through the turbine blade shown in figure 1, comprising a cavity and a plurality cooling holes,
- **Fig. 3a**: first step of the process of the invention, applying mask material the external surface of the component and the cooling holes of the component, shown as an example at one cooling hole,
- **Fig. 3b**: second step of the process of the invention, thickening the mask material in the cooling holes and line-of-sight through the cooling holes beyond the external surface of the component by means of an energy source from the cavity of the component,
- **Fig. 3c**: third step of the process of the invention, removing remaining liquid mask material from the external surface of the component,
- **Fig. 3d**: fourth step of the process of the invention, depositing the coating on the external surface of both the component and the masked cooling holes,
- **Fig. 3e**: fifth step of the process of the invention, the component after the removing the thickened mask material from the cooling holes and
- **Fig. 4**: a component with an insert within the cavity to avoid excessive mask material coming through the cooling with the insert usable as energy source at the same time.

The drawings show only the parts important for the invention. Same elements will be numbered in the same ways in different drawings.

### PREFERRED EMBODIMENT OF THE INVENTION

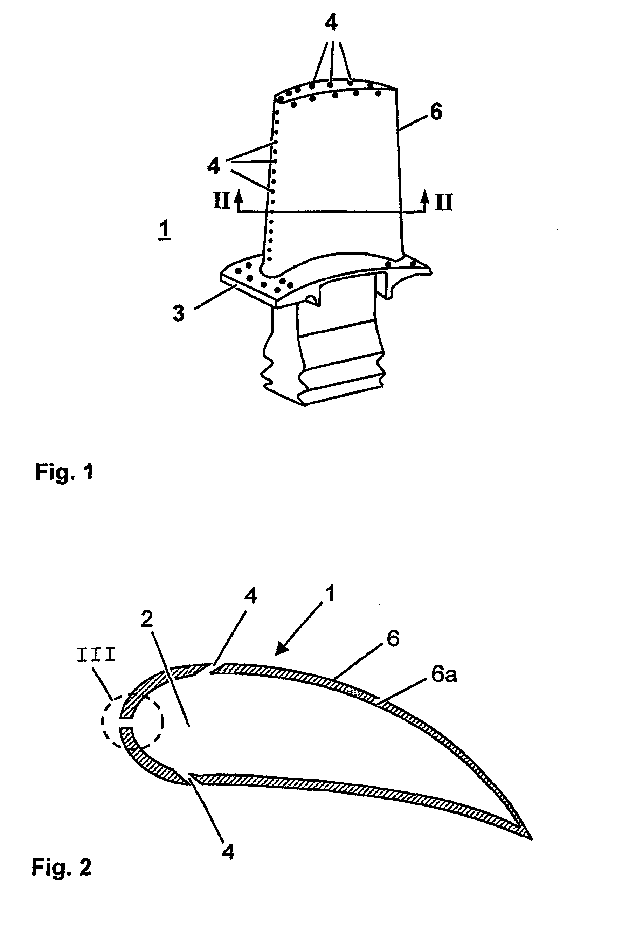

Figure 1 shows a component 1 such as blades or vanes of gas turbine engines comprising a cavity 2, not visible in figure 1, and cooling holes 4, which are on the external surface 6 of the component 1 as well as on the platform 3 of the component 1. The present invention relates to a process of masking cooling holes 4 in the component 1 before the deposition of coating material on the external surface 6 of the component 1 will take place.

According to line II-II in the figure 1 figure 2 shows a section through the component 1. The component 1 comprising a cavity 2 and three cooling holes 4. The number of the cooling holes 4 is given only as an example and may vary on the purpose the component 1 is used for. The component 1 has an external surface 6 and an internal surface 6a.

It is possible to apply the process for the coating of a new component 1 as well as to a component 1 which has to be repaired after use. In that case an already coated component 1 will by any means (chemical stripping with HCI, waterjet, high speed machining) be stripped of the coating to reveal the surface of the component 1. The external surface 6 of the component 1 and surfaces of the cooling holes 4 may be cleaned or otherwise prepared to receive the mask material 5.

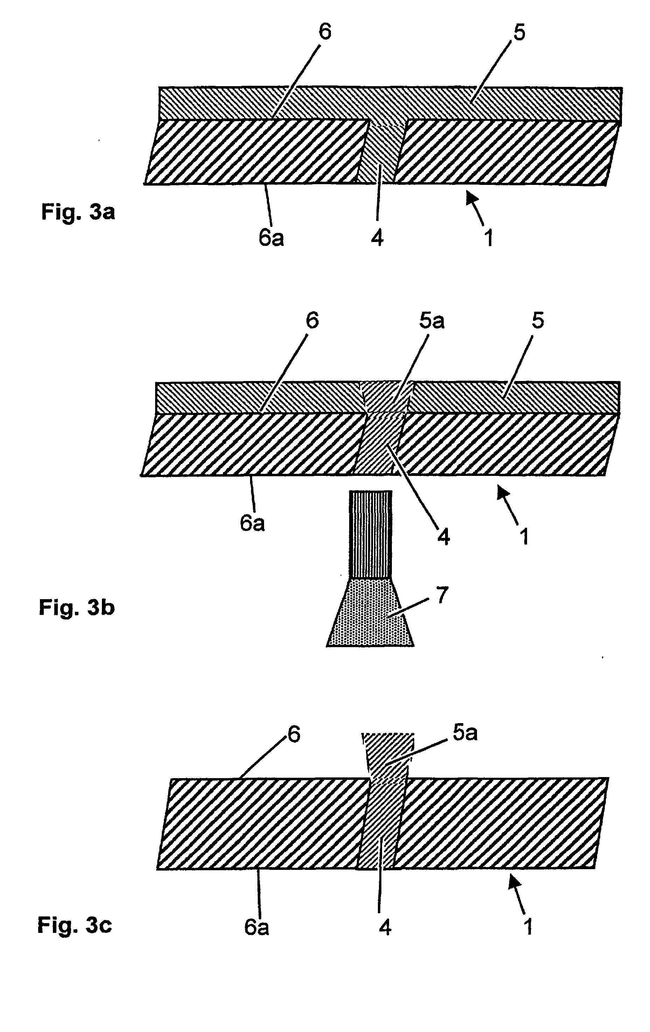

The steps of the process of the invention are given in figures 3a to 3e, which show a cooling holes 4 from the component 1 in detail as given as an example in the circle III in the figure 2.

The figure 3a shows the first step of the process according the invention. The external surface 6 and the cooling holes 4 are masked with the mask material 5. It will be coated with, sprayed with, or immersed in a material which is at least partially liquid, the mask material 5, and which thickens, which means to become more viscous or solid when exposed to an energy source 7. A way it may be done is to inject the mask material 5 into the cooling cavity 2 of the component 1 and force it through the cooling holes 4. Excess mask material 5 may be removed afterwards from the internal surface 6a (which can be the cavity 2 or one side of the platform 3 not to be coated) of the component 1 before the application of an energy source 7.

As mask material 5 different substances may be used:
1. a organic material or
2. a resin of a plastic, such as polyurethane, a polyurethane oligomer mixture, poly(isobutyl methacrylate), poly(vinyl toluene), polypropylene or a polypropylene / polyurethane oligomer mixture and the class of polymers vetones or silicones, or any photo-polymerizing resin or mix of resins.
3. the mask material 5 may also be a substance that is not at least partially liquid but rather a powder, which means a collection of solid particles. Thickening of the powder then refers to the agglomeration and the sticking together to form clumps or a large solid mass of individual powder particles. The powder would have to be sensitive to an energy source 7, which means that the powder particles agglomerate under the influence of the energy source 7.

The mask material 5 may contain particles or fibres of metal or oxide material such as silica, magnesia, calcia, alumina, zirconia, yttria or a mixture there of.

The mask material 5a thickened from the energy source 7 containing the metal or oxide particles may further be heated so as to volatilize or otherwise remove the organic portion of the thickened mask material 5a before the coating 8 are deposited on external surface 6 of the component 1. There may be included in the resin binding agents which are effective in holding together the solid particles of metal or oxide after the organic portion of the mask material 5a is removed.

Figures 3b shows the second step of the process according the invention. The desired energy source 7 will be placed on the side of the internal surface 6a so that the energy impinges directly on said mask material 5 which is in the cooling holes 4 and that portion of the mask material 5 which lies outside of the cooling holes 4 but is located essentially along a line-of-sight from inside the component 1 through the cooling holes 4. Figures 3b shows the thickened material 5a as well. In this way, the mask material 5 may be thickened to a desired length extending beyond the external surface 6 of the component 1 but along the line-of-sight through the cooling holes 4 of the component 1. The mask material 5 which lies on the external surface 6 of the component 1 and not in the aforementioned line-of-sight will not be thickened by the energy source 7, or will be thickened to a much lesser extent, and will be preferentially removed before the deposition of the coating material 8 as shown in figures 3d.

Different energy sources 7 may be used in order to obtain the desirable result:
1. it can be electromagnetic such as visible light, ultraviolet light or infrared light,
2. it can be a device providing collimated light such as a laser,
3. the energy source 7 can also be a device providing light of a single wavelength or a distribution of wavelengths centered around a desired wavelength with a narrow distribution band,
4. furthermore the energy source 7 may be introduced into the cavity 2 of the component 1 via an optical fiber or
5. the energy source 7 can be sonic vibrations ranging from infrasonic (below 20 Hz) to ultrasonic (above 20,000 Hz) frequencies. Is this case the energy source can be a transducer (i.e. an ultrasonic transducer).

Figure 3c shows the component 1 after the removal of the liquid mask material 5. The thickened mask material 5a in the cooling holes 4 and extending beyond the cooling holes 4, but along the line-of-sight through the cooling holes 4, will be left in place to prevent blocking of the cooling holes 4 during deposition of the coating material(s) 8, which can be as an example MCrAIY and TBC. Other coating materials 8 are possible.

The mask material 5 will be thickened to a length beyond the external surface 6 of the component that is at least equal to the thickness of the coating(s) 8 to be deposited, with a preferred length of 200% to 300% of the intended coating thickness. The mask material 5 may contain particles of solid material so that after thickening and with the proper heat treatment to volatilize part of the mask material 5, a porous solid form is left which can withstand the high temperatures of the diffusion heat treatment necessary for the bonding between base material of the component 1 and the MCrAIY coating, before applying the thermal barrier coating TBC. For elongated cooling holes, there may be inserted materials that are essentially transparent to the energy source 7 so that the length of reacting mask material 5 through which the energy must travel from inside the cavity of the component is not excessive.

Due to the different shapes of cooling holes, some may "grow" thickened mask material 5a outside of surface 6 of the cooling hole 4 faster than other cooling holes 4. It may therefore be appropriate to remove residual thickened mask material 5a (above the desired length beyond the external surface 6 of the component) from some cooling holes 4 prior to the deposition of the coating material(s) 8. This may be done, for example, by mechanical means.

As seen in figure 3d the plating of the coating 8 on the external surface 6 will take place directly on the masked cooling holes 4 with the means known in the state of the art.

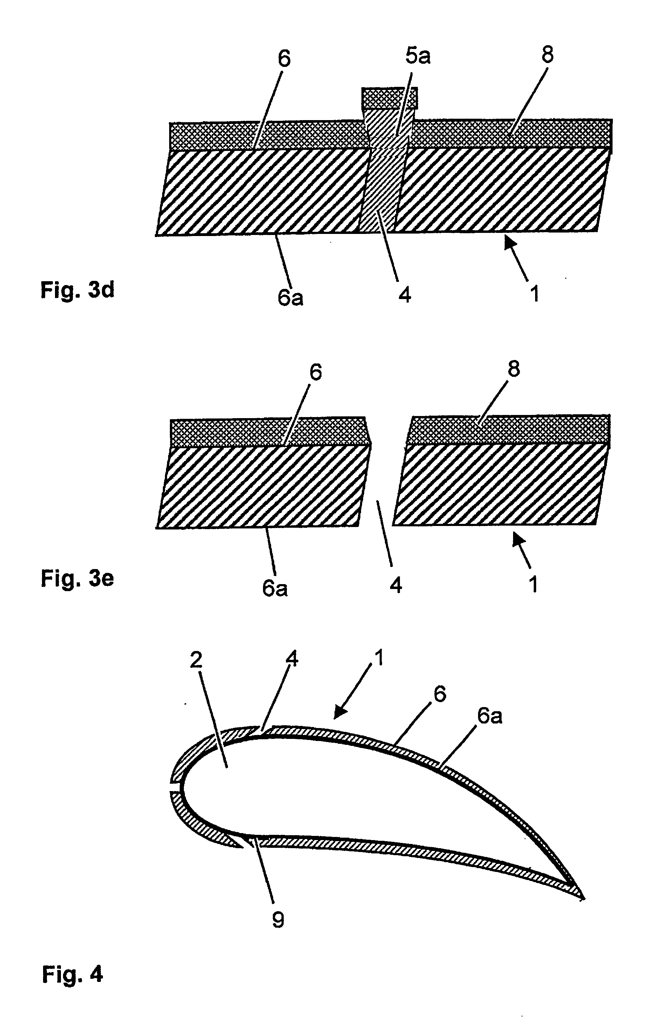

After the coating process(es) are completed, the thickened mask material 5a will be removed to reveal cooling holes 4 essentially free of coating material 8 and with walls that run consistently through the newly deposited coating material 8. This is shown in figure 3e. For example the removal of the thickening organic mask material can be accomplished by heating the part to 600°C in a vacuum furnace for 2 hours.

Beside the energy source 7 used it might be an advantage to place an insert 9 to the internal surface 6a within the cavity 2 of the component 1 as shown in figure 4. The insert 9 is essentially transparent to the type of energy used or the insert re-distributes or re-directs the energy from the energy source 7. In a preferred embodiment the insert 9 itself is the source of the energy 7, being specially shaped to fit into the cavity 2 of the component 1 to avoid excessive mask material 5 from thickening in the cavity 2. The insert 9 may have a special coating which allows the easy withdrawal from the component cavity 2 once the mask material 5 has been thickened.

It is possible that the component 1 is heated or cooled before or during processing to facilitate the polymerisation process.

The most important improvement of the present invention over the prior art is that the cooling holes 4 are re-formed during the coating deposition processes to their originally intended design, even through the thickness of the applied coating 8. In addition, the "line-of-sight" concept is a novel and very important part of the process. Due to the manufacturing process with which the cooling holes 4 are produced, which will be normally laser drilling, the "line-of-sight" of energy along the cooling holes 4 from within the cavity 2 of the component 1 will very closely re-produce the original hole design above the external surface 6 of the part through thickness of the coatings 8 to be applied.

### NUMBERING

- **1**: Component, e.g. blades or vanes for gas turbines
- **2**: Cavity
- **3**: Platform
- **4**: Cooling holes
- **5**: Mask material
- **5a**: Thickened mask material
- **6**: External surface
- **6a**: Internal surface
- **7**: Energy source
- **8**: Coating
- **9**: Insert

## Claims

1. Process of masking cooling holes (4) of a gas turbine component (1) with an external surface (6), comprising a cavity (2) and a plurality of cooling holes (4) before coating the gas turbine component (1),
**characterised in that**
- masking of both the external surface (6) of the component (1) and the cooling holes (4) with a mask material (5),
- exposing the cooling holes (4) to at least one energy source (7) from the cavity (2) of the component (1) and thereby thickening the mask material (5a) within the cooling holes (4) and along the line-of-sight through the cooling holes (4) beyond the external surface (6) of the component (1),
- removing mask material (5) unaffected by the energy source (7) from the external surface (6) of the component (1),
- coating (8) the component (1) and the masked cooling holes (4) and
- removing the thickened mask material (5a) from the cooling holes (4).

2. Process of claim 1,
**characterised in that**
the mask material (5) will be thickened to a length that is at least equal to the thickness of the coating (8) to be deposited beyond the external surface (6) of the component (1).

3. Process of claim 2,
**characterised in that**
the mask material (5) will be thickened to a length of 200%-300% of the coating (8) to be deposited beyond the external surface (6) of the component (1).

4. Process of one of the claims 1 to 3,
**characterised in that**
the masking will take place with an organic material.

5. Process of claim 4,
**characterised in that**
the masking will take place with a resin of a plastic, such as polyurethane, a polyurethane oligomer mixture, poly(isobutyl methacrylate), poly(vinyl toluene), polypropylene or a polypropylene / polyurethane oligomer mixture, the class of polymers vetones or silicones, or any photo-polymerizing resin or mix of resins.

6. Process of one of the claims 1 to 3,
**characterised in that**
the mask material (5) is a powder.

7. Process of one of the claims 4 to 6,
**characterised in that**
the mask material (5) contains particles or fibres of metal or oxide material such as silica, magnesia, calcia, alumina, zirconia, yttria or a mixture thereof.

8. Process of claim 7,
**characterised in that**
thickened mask material (5a) containing the metal or oxide particles is heated or processed so as to volatilize or otherwise remove the organic portion of the mask material (5) before the coating is deposited on external surface (6) the component (1).

9. Process of claim 7,
**characterised in that**
there are included in the mask material (5) binding agents which are effective in holding together the solid particles of metal or oxide after the organic portion of the mask material (5) is removed.

10. Process of one the claims 1 to 9,
**characterised in that**
an insert (9) which is essentially transparent to the type of energy used is placed in the cavity (2) of the component (1) before applying the process.

11. Process of one the claim 10,
**characterised in that**
the insert (9) re-directs or re-emits the energy.

12. Process of one the claim 10,
**characterised in that**
the insert (9) itself is the energy source (7).

13. Process of one the claims 1 to 12,
**characterised in that**
the component (1) is heated before or during processing to facilitate one of the process steps of claim 1.

14. Process of one the claims 1 to 12,
**characterised in that**
the component (1) is cooled before or during processing to facilitate one of the process steps of claim 1.

15. Process of one the claims 1 to 14,
**characterised in that**
an old coating (8) will be removed from the component (1) before applying the process.

## Patentansprüche

1. Maskierverfahren für Kühlöffnungen (4) eines Gasturbinenbauteils (1) mit einer äußeren Oberfläche (6), umfassend einen Hohlraum (2) und mehrere Kühlöffnungen (4), vor dem Beschichten des Gasturbinenbauteils (1), **gekennzeichnet durch**
- Maskieren sowohl der äußeren Oberfläche (6) des Bauteils (1) als auch der Kühlöffnungen (4) mit einem Maskierungsmaterial (5),
- Aussetzen der Kühlöffnungen (4) wenigstens einer Energiequelle (7) aus dem Hohlraum (2) des Bauteils (1) und **dadurch** Verdicken des Maskierungsmaterials (5a) innerhalb der Kühlöffnungen (4) und entlang der Sichtlinie **durch** die Kühlöffnungen (4) über die äußere Oberfläche (6) des Bauteils (1) hinaus,
- Entfernen des Maskierungsmaterials (5), welches **durch** die Energiequelle (7) nicht betroffen wurde, von der äußeren Oberfläche (6) des Bauteils (1),
- Beschichten (8) des Bauteils (1) und der maskierten Kühlöffnungen (4) und
- Entfernen des verdickten Maskierungsmaterials (5a) aus den Kühlöffnungen (4).

2. Verfahren nach Anspruch 1, **dadurch gekennzeichnet, dass** das Maskierungsmaterial (5) auf einer Länge verdickt wird, welche wenigstens gleich der Dicke der Beschichtung (8) ist, welche über der äußeren Oberfläche (6) des Bauteils (1) abzulagern ist.

3. Verfahren nach Anspruch 2, **dadurch gekennzeichnet, dass** das Maskierungsmaterial (5) auf einer Länge von 200 % bis 300 % der Beschichtung (8) verdickt wird, welche über der äußeren Oberfläche (6) des Bauteils (1) abzulagern ist.

4. Verfahren nach einem der Ansprüche 1 bis 3, **dadurch gekennzeichnet, dass** die Maskierung mit einem organischen Material stattfindet.

5. Verfahren nach Anspruch 4, **dadurch gekennzeichnet, dass** die Maskierung mit einem Kunststoffharz, wie beispielsweise Polyurethan, einer Polyurethan-Oligomerenmischung, Polyisobutylmethacrylat, Polyvinyltoluol, Polypropylen oder einer Polypropylen- / Polyurethan-Oligomerenmischung, der Polymerklasse der Ketone oder Silikone oder irgendeinem photopolymerisierenden Harz oder Harzmischung stattfindet.

6. Verfahren nach einem der Ansprüche 1 bis 3, **dadurch gekennzeichnet, dass** das Maskierungsmaterial (5) ein Pulver ist.

7. Verfahren nach einem der Ansprüche 4 bis 6, **dadurch gekennzeichnet, dass** das Maskierungsmaterial (5) Partikel oder Fasern aus Metall oder Oxidmaterial wie beispielsweise Kieselerde, Magnesiumoxid, Kalziumoxid, Aluminiumoxid, Zirkonoxid, Yttriumoxid oder eine Mischung davon enthält.

8. Verfahren nach Anspruch 7, **dadurch gekennzeichnet, dass** das verdickte Maskierungsmaterial (5a), welches die Metall- oder Oxidpartikel enthält, erhitzt oder behandelt wird, um den organischen Anteil des Maskierungsmaterials (5) zu verflüchtigen oder auf andere Weise zu entfernen, bevor die Beschichtung auf der äußeren Oberfläche (6) des Bauteils (1) abgelagert wird.

9. Verfahren nach Anspruch 7, **dadurch gekennzeichnet, dass** im Maskierungsmaterial (5) Bindemittel miteingeschlossen sind, welche beim Zusammenhalt der festen Metall- oder Oxidpartikel wirksam sind, nachdem der organische Anteil des Maskierungsmaterials (5) entfernt wurde.

10. Verfahren nach einem der Ansprüche 1 bis 9, **dadurch gekennzeichnet, dass** ein Einsatz (9), welcher im Wesentlichen transparent für die verwendete Energieart ist, im Hohlraum (2) des Bauteils (1) platziert wird, bevor das Verfahren angewendet wird.

11. Verfahren nach Anspruch 10, **dadurch gekennzeichnet, dass** der Einsatz (9) die Energie umlenkt oder erneut abstrahlt.

12. Verfahren nach Anspruch 10, **dadurch gekennzeichnet, dass** der Einsatz (9) selbst die Energiequelle (7) ist.

13. Verfahren nach einem der Ansprüche 1 bis 12, **dadurch gekennzeichnet, dass** das Bauteil (1) vor oder während der Ausführung erhitzt wird, um einen der Verfahrensschritte nach Anspruch 1 zu erleichtern.

14. Verfahren nach einem der Ansprüche 1 bis 12, **dadurch gekennzeichnet, dass** das Bauteil (1) vor oder während der Ausführung gekühlt wird, um einen der Verfahrensschritte nach Anspruch 1 zu erleichtern.

15. Verfahren nach einem der Ansprüche 1 bis 14, **dadurch gekennzeichnet, dass** vor der Anwendung des Verfahrens eine alte Beschichtung (8) vom Bauteil (1) entfernt wird.

## Revendications

1. Procédé pour masquer les orifices de refroidissement (4) d'un composant (1) d'une turbine à gaz avec une surface extérieure (6), comprenant une cavité (2) et une pluralité d'orifices de refroidissement (4), avant le revêtement du composant (1) de la turbine à gaz,
**caractérisé par**
- le masquage de la surface extérieure (6) du composant (1) et des orifices de refroidissement (4) avec un matériau de masquage (5),
- l'exposition des orifices de refroidissement (4) à au moins une source d'énergie (7) provenant de la cavité (2) du composant (1) en épaississant ainsi le matériau de masquage (5a) dans les orifices de refroidissement (4) et le long de la ligne de visée à travers les orifices de refroidissement (4) au-delà de la surface extérieure (6) du composant (1),
- enlever le matériau de masquage (5) non affecté par la source d'énergie (7) de la surface extérieure (6) du composant (1),
- revêtir (8) le composant (1) et les orifices de refroidissement (4) masqués et
- enlever le matériau de masquage épaissi (5a) des orifices de refroidissement (4).

2. Procédé selon la revendication 1,
**caractérisé en ce que**
le matériau de masquage (5) sera épaissi à une longueur au-delà de la surface extérieure (6) du composant (1) qui est au moins égale à l'épaisseur du revêtement (8) à déposer.

3. Procédé selon la revendication 2,
**caractérisé en ce que**
le matériau de masquage (5) sera épaissi sur une longueur au-delà de la surface extérieure (6) du composant (1) de 200% - 300% du revêtement (8) à déposer.

4. Procédé selon l'une quelconque des revendications 1 à 3,
**caractérisé en ce que**
le masquage s'effectuera au moyen d'un matériau organique.

5. Procédé selon la revendication 4,
**caractérisé en ce que**
le masquage s'effectuera avec une résine de plastique, telle qu'un polyuréthane, un mélange d'oligomères de polyuréthane, un polyméthacrylate d'isobutyle, du polyvinyltoluène, du polypropylène ou un mélange d'oligomères de polypropylène / polyuréthane, la classe de polymères vétones ou silicones, ou toute résine photopolymérisante ou mélange de résines.

6. Procédé selon l'une quelconque des revendications 1 à 3,
**caractérisé en ce que**
le matériau de masquage (5) est une poudre.

7. Procédé selon l'une quelconque des revendications 4 à 6,
**caractérisé en ce que**
le matériau de masquage (5) contient des particules ou des fibres de métal ou d'oxyde tel que de la silice, de la magnésie, de l'oxyde de calcium, de l'alumine, de la zircone, de l'oxyde d'yttrium ou un mélange de ceux-ci.

8. Procédé selon la revendication 7,
**caractérisé en ce que**
le matériau de masquage épaissi (5a) contenant les particules de métal ou d'oxyde est chauffé ou traité de manière à volatiliser ou à éliminer d'une autre façon la portion organique du matériau de masquage (5) avant que le revêtement ne soit déposé sur la surface extérieure (6) du composant (1).

9. Procédé selon la revendication 7,
**caractérisé en ce que**
le matériau de masquage (5) contient des agents liants qui permettent de maintenir efficacement ensemble les particules solides de métal ou d'oxyde après que la portion organique du matériau de masquage (5) a été éliminée.

10. Procédé selon l'une quelconque des revendications 1 à 9,
**caractérisé en ce que**
l'on place un insert (9), qui est essentiellement transparent au type d'énergie utilisée, dans la cavité (2) du composant (1) avant d'appliquer le procédé.

11. Procédé selon la revendication 10,
**caractérisé en ce que**
l'insert (9) ré-oriente ou ré-émet l'énergie.

12. Procédé selon la revendication 10,
**caractérisé en ce que**
l'insert (9) lui-même est la source d'énergie (7).

13. Procédé selon l'une quelconque des revendications 1 à 12,
**caractérisé en ce que**
le composant (1) est chauffé avant ou au cours du traitement pour faciliter l'une des étapes de procédé de la revendication 1.

14. Procédé selon l'une quelconque des revendications 1 à 12,
**caractérisé en ce que**
le composant (1) est refroidi avant ou au cours du traitement pour faciliter l'une des étapes de procédé de la revendication 1.

15. Procédé selon l'une quelconque des revendications 1 à 14,
**caractérisé en ce que**
l'on enlèvera un ancien revêtement (8) du composant (1) avant d'appliquer le procédé.
